# EUROPÄISCHE PATENTANMELDUNG

(11) **EP 4 718 653 A1**
(43) Veröffentlichungstag der Anmeldung: **01.04.2026**
(21) Anmeldenummer: 24202466.9
(22) Anmeldetag: 25.09.2024
(51) Int. Cl.: H02H 3/28, H02H 3/04, G01R 31/08

(54) **KUPPLUNGSDIFFERENTIALSCHUTZVERFAHREN UND EINRICHTUNGEN FÜR KUPPLUNGSDIFFERENTIALSCHUTZVERFAHREN**

(71) Anmelder: Siemens Aktiengesellschaft, 80333 München (DE)
(72) Erfinder: Henn, Volker, 91056 Erlangen (DE); Romeis, Christian, 91052 Erlangen (DE)
(74) Vertreter: Siemens Patent Attorneys

(57) **Zusammenfassung**

Die Erfindung bezieht sich unter anderem auf ein Kupplungsdifferentialschutzverfahren zum Überwachen eines Kuppelabschnitts (11), der einen zwei Sammelschienen (20, 30) verbindenden Kuppelschalter (12) umfasst, wobei bei dem Verfahren mit einem einer ersten Anschlussseite (A1) des Kuppelschalters (12) zugeordneten Stromwandler (SW1) der Strom auf der ersten Anschlussseite (A1) unter Bildung eines ersten Messsignals (Im1) gemessen wird, mit einem einer zweiten Anschlussseite (A2) des Kuppelschalters (12) zugeordneten Stromwandler (SW2) der Strom auf der zweiten Anschlussseite (A2) unter Bildung eines zweiten Messsignals (Im2) gemessen wird und auf einen Fehler erkannt und der Kuppelschalter (12) geöffnet wird, wenn das erste und zweite Messsignal (Im1, Im2) über ein vorgegebenes Maß hinaus voneinander abweichen. Erfindungsgemäß ist vorgesehen, dass ermittelt wird, ob der Fehler auf der ersten Anschlussseite (A1) oder auf der zweiten Anschlussseite (A2) aufgetreten ist, indem nach dem Öffnen des Kuppelschalters (12) der zeitliche Verlauf des ersten und zweiten Messsignals (Im1, Im2) beobachtet wird und in Abhängigkeit von den zeitlichen Verläufen der Messsignale (Im1, Im2) unmittelbar nach dem Öffnungsvorgang die erste und/oder die zweite Anschlussseite (A1, A2) als vom Fehler betroffen oder fehlerfrei identifiziert wird.

Fig. 4

## Beschreibung

Die Erfindung bezieht sich auf ein Kupplungsdifferentialschutzverfahren zum Überwachen eines Kuppelabschnitts, der einen zwei Sammelschienen verbindenden Kuppelschalter umfasst, wobei bei dem Verfahren mit einem einer ersten Anschlussseite des Kuppelschalters zugeordneten Stromwandler der Strom auf der ersten Anschlussseite unter Bildung eines ersten Messsignals gemessen wird, mit einem einer zweiten Anschlussseite des Kuppelschalters zugeordneten Stromwandler der Strom auf der zweiten Anschlussseite unter Bildung eines zweiten Messsignals gemessen wird und auf einen Fehler erkannt und der Kuppelschalter geöffnet wird, wenn das erste und zweite Messsignal über ein vorgegebenes Maß hinaus voneinander abweichen.

Derartige Kupplungsdifferentialschutzverfahren sind im Bereich der Überwachung von Energieversorgungs- bzw. Energieverteilnetzen allgemein bekannt und werden von entsprechenden Schutzgeräten ausgeführt.

Der Erfindung liegt die Aufgabe zugrunde, ein Kupplungsdifferentialschutzverfahren anzugeben, bei dem im Falle eines Fehlers im Bereich des Kuppelabschnitts ein besonders schnelles Abschalten auch der mit der Fehlerstelle verbundenen Sammelschiene erreichbar ist.

Diese Aufgabe wird erfindungsgemäß durch ein Verfahren mit den Merkmalen gemäß Patentanspruch 1 gelöst. Vorteilhafte Ausgestaltungen des erfindungsgemäßen Verfahrens sind in Unteransprüchen angegeben.

Danach ist erfindungsgemäß vorgesehen, dass ermittelt wird, ob der Fehler auf der ersten Anschlussseite oder auf der zweiten Anschlussseite aufgetreten ist, indem nach dem Öffnen des Kuppelschalters der zeitliche Verlauf des ersten und zweiten Messsignals beobachtet wird und in Abhängigkeit von den zeitlichen Verläufen der Messsignale unmittelbar nach dem Öffnungsvorgang die erste und/oder die zweite Anschlussseite als vom Fehler betroffen oder als fehlerfrei identifiziert wird.

Ein wesentlicher Vorteil des erfindungsgemäßen Kupplungsdifferentialschutzverfahrens besteht darin, dass die Information über die vom Fehler betroffene Anschlussseite unmittelbar nach dem Öffnen des Kuppelschalters bereits im Rahmen des Kupplungsdifferentialschutzverfahrens ermittelt wird. Diese Information kann unmittelbar für weitere Schutzmaßnahmen genutzt werden. Beispielsweise kann diejenige Sammelschiene, die mit der vom Fehler betroffenen Anschlussseite verbunden ist, bereits bei Vorliegen dieser Information abgeschaltet bzw. elektrisch abgetrennt werden, sei es mit oder ohne Einbezug einer die betroffene Sammelschiene überwachenden Sammelschienendifferentialschutzeinrichtung. Mit anderen Worten lassen sich Sammelschienendifferentialschutzeinrichtungen, die den Sammelschienen zugeordnet sind, von der Aufgabe befreien, nach einem Fehler im Kuppelschalterabschnitt und einem Öffnen des Kuppelschalters zu prüfen bzw. zu erkennen, ob bzw. dass ihre zugeordnete Sammelschiene mit der fehlerbehafteten Anschlussseite verbunden ist und aus diesem Grunde elektrisch isoliert werden muss, denn diese Aufgabe wird zeitsparend bereits von dem Kupplungsdifferentialschutzverfahren miterledigt.

Vorteilhaft ist es, wenn diejenige der beiden Anschlussseiten als vom Fehler betroffen angesehen wird, bei der das Messsignal trotz Öffnens des Kuppelschalters im Wesentlichen unverändert bleibt oder ansteigt.

Vorzugsweise wird diejenige der beiden Anschlussseiten als vom Fehler betroffen angesehen, bei der das Messsignal trotz Öffnens des Kuppelschalters ansteigt oder um maximal 10 % abfällt.

Alternativ oder zusätzlich kann vorgesehen sein, dass diejenige der beiden Anschlussseiten als fehlerfrei angesehen wird, bei der das Messsignal in Reaktion auf den Öffnungsvorgang um mindestens 20 % einbricht.

Vorzugsweise wird diejenige der beiden Anschlussseiten als fehlerfrei angesehen, bei der das Messsignal in Reaktion auf den Öffnungsvorgang auf Null abfällt.

Alternativ oder zusätzlich kann in vorteilhafter Weise vorgesehen sein, dass diejenige der beiden Anschlussseiten als vom Fehler betroffen angesehen wird, bei der das Messsignal nach Öffnen des Kuppelschalters weniger als bei der anderen Anschlussseite abfällt, und/oder diejenige der beiden Anschlussseiten als fehlerfrei angesehen wird, bei der das Messsignal nach Öffnen des Kuppelschalters stärker als bei der anderen Anschlussseite abfällt.

Wenn es sich bei dem gemessenen Strom um einen Wechselstrom und bei dem Messsignal um ein Wechselsignal handelt, bezieht sich die Feststellung, ob das Messsignal nach dem Öffnen des Kuppelschalters unverändert bleibt, ansteigt oder abfällt, vorzugsweise auf den Scheitelwert oder den Effektivwert des jeweiligen Wechselsignals.

Nach dem Identifizieren der vom Fehler betroffenen Anschlussseite wird die an diese Anschlussseite angeschlossene Sammelschiene vorzugsweise von einem an diese angeschlossenen Energieverteilnetz abgetrennt.

Alternativ oder zusätzlich kann vorgesehen sein, dass nach dem Identifizieren der fehlerfreien Anschlussseite die andere Anschlussseite vom Energieverteilnetz abgetrennt wird.

Die Sammelschienen werden vorzugsweise jeweils mit einer Sammelschienendifferentialschutzeinrichtung überwacht, die für jeden Abzweig der jeweiligen Sammelschiene jeweils einen Abzweigschalter umfasst und im Falle eines sammelschienenbezogenen Fehlers ihre zugeordnete Sammelschiene durch Öffnen der Abzweigschalter von dem zugeordneten Energieverteilnetz abtrennt.

Wie bereits eingangs angesprochen, ist es von Vorteil, wenn nach dem Identifizieren der vom Fehler betroffenen Anschlussseite die an diese Anschlussseite angeschlossene Sammelschiene von dem daran angeschlossenen Energieverteilnetz abgetrennt wird, indem die Abzweigschalter der Sammelschienendifferentialschutzeinrichtung der jeweiligen Sammelschiene geöffnet werden.

Bei einer als vorteilhaft angesehenen Ausführungsvariante ist vorgesehen, dass nach dem Identifizieren der vom Fehler betroffenen Anschlussseite die an diese Anschlussseite angeschlossene Sammelschiene von dem Energieverteilnetz abgetrennt wird, indem ein Abschaltbefehl und/oder eine die Anschlussseite und/oder die Sammelschiene und/oder die Sammelschienendifferentialschutzeinrichtung identifizierende Fehlerinformation an die Sammelschienendifferentialschutzeinrichtung übermittelt wird und die Sammelschienendifferentialschutzeinrichtung in Reaktion auf den Abschaltbefehl oder die Fehlerinformation ihre Abzweigschalter öffnet.

Bei einer anderen als vorteilhaft angesehenen Ausführungsvariante ist vorgesehen, dass nach dem Identifizieren der vom Fehler betroffenen Anschlussseite die an diese Anschlussseite angeschlossene Sammelschiene von dem Energieverteilnetz abgetrennt wird, indem unter Umgehung der Sammelschienendifferentialschutzeinrichtung die Abzweigschalter der Sammelschienendifferentialschutzeinrichtung unmittelbar geöffnet werden.

Nach dem Identifizieren der fehlerfreien Anschlussseite bleibt die an diese Anschlussseite angeschlossene Sammelschiene vorzugsweise mit einem daran angeschlossenen Energieverteilnetz verbunden.

Bei einer als vorteilhaft angesehenen Ausgestaltung ist vorgesehen, dass der der ersten Anschlussseite des Kuppelschalters zugeordnete Stromwandler und der der zweiten Anschlussseite des Kuppelschalters zugeordnete Stromwandler kuppelabschnittseigene Stromwandler der Kuppelungsdifferentialschutzeinrichtung sind.

Bei einer anderen als vorteilhaft angesehenen Ausgestaltung ist vorgesehen, dass der der ersten Anschlussseite des Kuppelschalters zugeordnete Stromwandler ein abzweigbezogener Stromwandler der Sammelschienendifferentialschutzeinrichtung einer ersten der beiden Sammelschienen ist und der der zweiten Anschlussseite des Kuppelschalters zugeordnete Stromwandler ein abzweigbezogener Stromwandler der Sammelschienendifferentialschutzeinrichtung einer zweiten der beiden Sammelschienen ist.

Die Erfindung bezieht sich außerdem auf eine Kuppelungsdifferentialschutzeinrichtung zum Überwachen eines Kuppelabschnitts, der einen zwei Sammelschienen verbindenden Kuppelschalter umfasst, insbesondere zum Durchführen eines Kupplungsdifferentialschutzverfahrens wie oben beschrieben. Erfindungsgemäß ist die Kuppelungsdifferentialschutzeinrichtung mit einer Auswerteinrichtung ausgestattet, die dazu ausgestaltet ist, auf einen Fehler zu schließen und einen das Öffnen des Kuppelschalters auslösenden Steuerbefehl zu erzeugen, wenn ein erstes Messsignal, das einen auf einer ersten Anschlussseite des Kuppelschalters fließenden Strom beschreibt, von einem zweiten Messsignal, das einen auf der zweiten Anschlussseite des Kuppelschalters fließenden Strom beschreibt, über ein vorgegebenes Maß hinaus abweicht. Die Auswerteinrichtung ist außerdem dazu ausgestaltet, nach dem Öffnen des Kuppelschalters den zeitlichen Verlauf des ersten und zweiten Messsignals zu beobachten und in Abhängigkeit von den Verläufen der Messsignale unmittelbar nach dem Öffnungsvorgang die erste und/oder die zweite Anschlussseite als vom Fehler betroffen oder als fehlerfrei zu identifizieren.

Bezüglich der Vorteile der erfindungsgemäßen Kuppelungsdifferentialschutzeinrichtung und deren vorteilhafter Ausgestaltungen sei auf die obigen Ausführungen im Zusammenhang mit dem erfindungsgemäßen Kupplungsdifferentialschutzverfahren und dessen vorteilhafter Ausgestaltungen verwiesen.

Nach dem Identifizieren der vom Fehler betroffenen Anschlussseite erzeugt die Auswerteinrichtung vorzugsweise eine die Anschlussseite identifizierende Fehlerinformation und/oder einen entsprechenden Abschaltbefehl zum Öffnen von Abzweigschaltern derjenigen Sammelschiene, die mit der vom Fehler betroffenen Anschlussseite verbunden ist.

Die Erfindung bezieht sich außerdem auf ein Computerprogrammprodukt. Erfindungsgemäß umfasst dieses Programmbefehle, um eine Datenverarbeitungsanlage zu veranlassen, die Auswerteinrichtung der beschriebenen Kuppelungsdifferentialschutzeinrichtung zu bilden und/oder ein Kupplungsdifferentialschutzverfahren wie oben beschrieben durchzuführen.

Die Erfindung bezieht sich außerdem auf eine Datenverarbeitungsanlage. Erfindungsgemäß ist diese mit einem Computer-Programmprodukt wie oben beschrieben programmiert oder es ist zumindest ein solches Computer-Programmprodukt in einem Speicher der Datenverarbeitungsanlage abgespeichert.

Die Erfindung wird nachfolgend anhand von Ausführungsbeispielen näher erläutert; dabei zeigen beispielhaft:
- Fig. 1: eine Anordnung, die mit einem ersten Ausführungsbeispiel für eine erfindungsgemäße Kuppelungsdifferentialschutzeinrichtung ausgestattet ist, vor Eintritt eines Fehlers in einem Kuppelabschnitt,
- Fig. 2: die Anordnung gemäß Figur 1 nach Eintritt eines Fehlers im Kuppelabschnitt,
- Fig. 3: zeitliche Verläufe von Messsignalen, die Ströme auf den beiden Anschlussseiten des Kuppelabschnitts beschreiben,
- Fig. 4: eine besonders bevorzugte Arbeitsweise der Kuppelungsdifferentialschutzeinrichtung bei der Anordnung gemäß den Figuren 1 und 2,
- Fig. 5: eine weitere Anordnung, die mit einem zweiten Ausführungsbeispiel für eine erfindungsgemäße Kuppelungsdifferentialschutzeinrichtung ausgestattet ist, nach Eintritt eines Fehlers im Kuppelabschnitt und
- Fig. 6: eine Ausführungsvariante des zweiten Ausführungsbeispiels gemäß Figur 5.

In den Figuren werden der Übersicht halber für identische oder vergleichbare Komponenten stets dieselben Bezugszeichen verwendet.

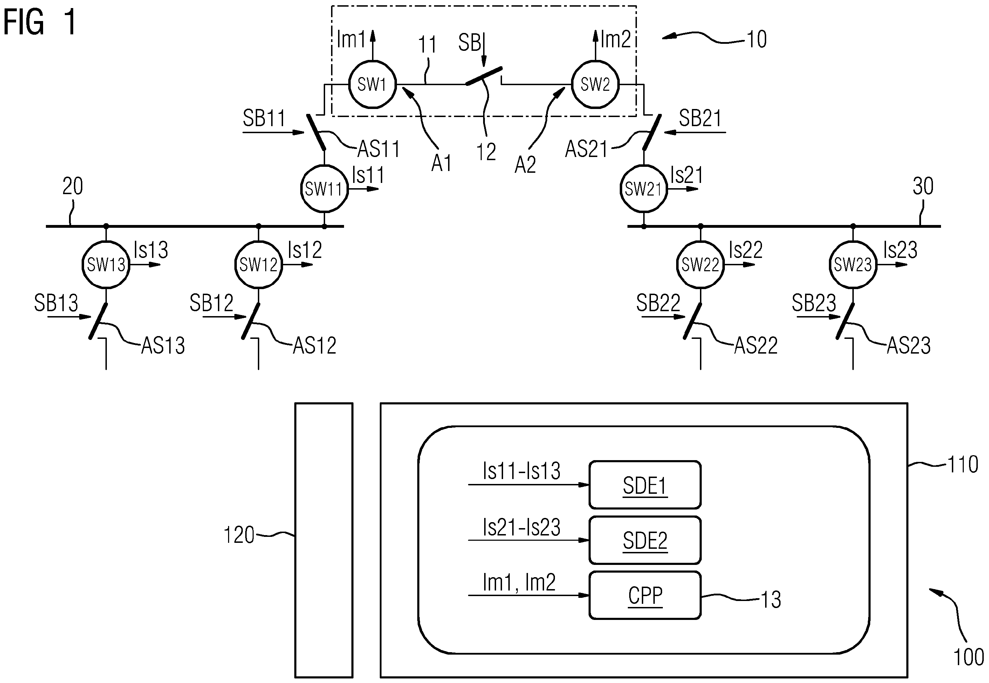

Die Figur 1 zeigt eine Anordnung, die mit einem Ausführungsbeispiel für eine erfindungsgemäße Kuppelungsdifferentialschutzeinrichtung 10 ausgestattet ist und anhand derer nachfolgend Ausführungsbeispiele für erfindungsgemäße Kupplungsdifferentialschutzverfahren erläutert werden.

Die Anordnung umfasst neben der genannten Kuppelungsdifferentialschutzeinrichtung 10 eine erste Sammelschiene 20 und eine zweite Sammelschiene 30. Die beiden Sammelschienen 20 und 30 können jeweils eine Vielzahl an Abzweigen aufweisen; nachfolgend wird beispielhaft davon ausgegangen, dass jede jeweils mit drei Abzweigen ausgestattet ist. Jeder der Abzweige ist jeweils mit einem Abzweigschalter AS11-AS13 bzw. AS21-AS23 und einem Abzweigstromwandler SW11-SW13 bzw. SW21-SW23 ausgestattet.

Die Abzweigstromwandler SW11-SW13 bzw. SW21-SW23 messen jeweils den durch den zugeordneten Abzweig fließenden Strom unter Erzeugung von strombezogenen Messsignalen, die in der Figur 1 mit den Bezugszeichen Is11-Is13 bzw. Is21-Is23 bezeichnet sind. Die strombezogenen Messsignale können analoge oder digitale Signale, insbesondere binäre Signale, sein. Die Abzweigschalter AS11-AS13 bzw. AS21-AS23 sind durch Steuerbefehle SB11-SB13 bzw. SB21-SB23 ein- bzw. ausschaltbar.

Der ersten Sammelschiene 20 ist eine erste Sammelschienendifferentialschutzeinrichtung SDE1 zugeordnet, die die Messsignale Is11 bis Is13 der Abzweigstromwandler SW11-SW13 auswertet, wie dies für Sammelschienendifferentialschutzeinrichtungen allgemein bekannt ist: Weicht die Stromsumme der Messsignale Is11 bis Is13 der ersten Sammelschiene 20 über ein vorgegebenes Maß von Null ab, so öffnet die erste Sammelschienendifferentialschutzeinrichtung SDE1 mittels der Steuerbefehle SB11-SB13 die zugeordneten Abzweigschalter AS11-AS13 und trennt die erste Sammelschiene 20 elektrisch ab.

Der zweiten Sammelschiene 30 ist eine zweite Sammelschienendifferentialschutzeinrichtung SDE2 zugeordnet, die die Messsignale Is21 bis Is23 der zweiten Sammelschiene 30 auswertet: Weicht die Stromsumme der Messsignale Is21 bis Is23 der zweiten Sammelschiene 30 über ein vorgegebenes Maß von Null ab, so öffnet die zweite Sammelschienendifferentialschutzeinrichtung SDE2 mittels der Steuerbefehle SB21-SB23 die zugeordneten Abzweigschalter AS21-AS23 und trennt die zweite Sammelschiene 30 elektrisch ab.

Die Kuppelungsdifferentialschutzeinrichtung 10 dient zum Überwachen eines Kuppelabschnitts 11, der einen die zwei Sammelschienen 20 und 30 verbindenden Kuppelschalter 12 umfasst. Die Kuppelungsdifferentialschutzeinrichtung 10 ist ausgestattet mit einem auf einer ersten Anschlussseite A1 des Kuppelschalters 12 angeordneten Stromwandler SW1 zum Messen eines durch den Kuppelschalter 12 fließenden Stroms unter Bildung eines ersten strombezogenen Messsignals Im1, einem auf einer zweiten Anschlussseite A2 des Kuppelschalters 12 angeordneten Stromwandler SW2 zum Messen des durch den Kuppelschalter 12 fließenden Stroms unter Bildung eines zweiten strombezogenen Messsignals Im2 und einer Auswerteinrichtung 13. Bei den strombezogenen Messsignalen Im1 und Im2 kann es sich wieder um analoge oder digitale, beispielsweise binäre Signale handeln.

Die Auswerteinrichtung 13 wird durch ein Computerprogrammprodukt CPP gebildet. Das Computerprogrammprodukt CPP ist in einem Speicher 110 einer Datenverarbeitungsanlage 100 abgespeichert ist und wird von einer Recheneinrichtung 120 der Datenverarbeitungsanlage 100 ausgeführt. Auch die beiden Sammelschienendifferentialschutzeinrichtungen können softwaremäßig realisiert sein und als Softwaremodule beispielsweise ebenfalls in dem Speicher 110 abgespeichert sein und von der Recheneinrichtung 120 ausgeführt werden.

Handelt es sich bei den strombezogenen Messsignalen Is11-Is13 bzw. Is21-Is23, die von den Abzweigstromwandlern SW11-SW13 bzw. SW21-SW23 geliefert werden, um analoge Signale, so werden diese vorzugsweise vor der Verarbeitung in der Datenverarbeitungsanlage 100 oder von der Recheneinrichtung 120 der Datenverarbeitungsanlage 100 zunächst analog-digital gewandelt, um eine computergestützte Verarbeitung zu vereinfachen.

Die Auswerteinrichtung 13 der Kuppelungsdifferentialschutzeinrichtung 10 ist dazu ausgestaltet, auf einen Fehler zu schließen und einen das Öffnen des Kuppelschalters 12 auslösenden Steuerbefehl SB zu erzeugen, wenn das erste und zweite Messsignal Im1 und Im2 über ein vorgegebenes Maß hinaus voneinander abweichen. Darüber hinaus ist die Auswerteinrichtung 13 dazu ausgestaltet, nach dem Öffnen des Kuppelschalters 12 zum Zeitpunkt t0 den Verlauf des ersten und zweiten Messsignals Im1 und Im2 über der Zeit t zu beobachten und in Abhängigkeit von deren Verläufen unmittelbar nach dem Öffnungsvorgang die erste oder die zweite Anschlussseite A1 bzw. A2 als vom Fehler betroffen zu identifizieren.

Die Kuppelungsdifferentialschutzeinrichtung 10 gemäß Figur 1 arbeitet vorzugsweise wie folgt:
In einem fehlerfreien Betrieb wird das erste Messsignal Im1 dem zweiten Messsignal Im2 entsprechen, sodass die Kuppelungsdifferentialschutzeinrichtung 10 den Kuppelschalter 12 geschlossen halten kann.

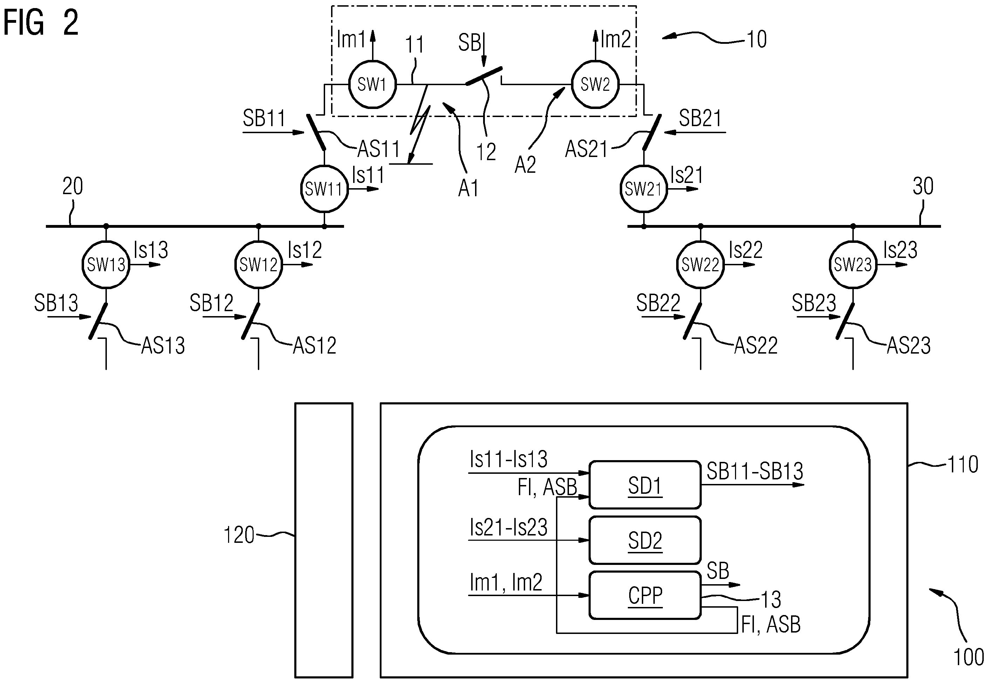

Tritt im Bereich des Kuppelabschnitts 11 ein Fehler auf, beispielsweise ein Kurzschluss, durch den ein Teil des Stromes aus dem Kuppelabschnitt 11 abfließt, so wird die Auswerteinrichtung 13 eine Differenz zwischen den beiden Messsignalen Im1 und Im2 feststellen und einen Steuerbefehl SB zum Öffnen des Kuppelschalters 12 erzeugen, wie beispielhaft die Figur 2 zeigt.

Nach dem Öffnen des Kuppelschalters 12 überwacht die Auswerteinrichtung 13 die Messsignale Im1 und Im2 weiterhin. Je nach der Lage des Fehlers, also in der Figur 2 rechts oder links des Kuppelschalters 12, werden die Messsignale Im1 und Im2 unterschiedlich aussehen.

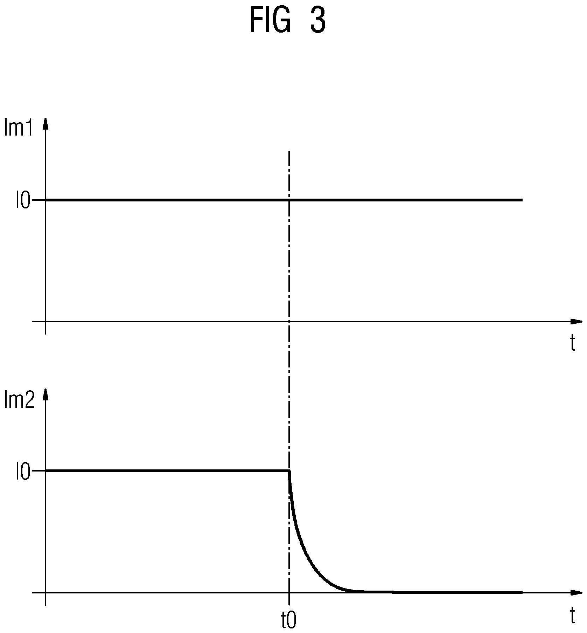

Liegt der Fehler links vom Kuppelschalter 12, wie beispielhaft in der Figur 2 gezeigt ist, also auf der ersten Anschlussseite A1, so wird das Messsignal Im2 des auf der zweiten Anschlussseite A2 befindlichen zweiten Stromwandlers SW2 einbrechen und auf Null oder zumindest näherungsweise Null abfallen, wie die Figur 3 anhand der zeitlichen Verläufe der Messsignale Im1 und Im2 über der Zeit t beispielhaft zeigt. Das Messsignal des auf der ersten Anschlussseite A1 befindlichen ersten Stromwandlers SW1 wird hingegen im Wesentlichen gleichbleiben, also den Wert I0 vor dem Öffnen beibehalten, oder kann - je nach der Verschaltungssituation eines an die beiden Sammelschienen 20 und 30 angeschlossenen Energieversorgungsnetzes sogar ansteigen.

Durch Auswertung der zeitlichen Verläufe der beiden Messsignale Im1 und Im2 kann die Auswerteinrichtung 13 also eine Fehlerinformation FI erzeugen, die die Lage des Fehlers angibt und damit die vom Fehler betroffene Anschlussseite identifiziert. Diese Fehlerinformation FI kann die Auswerteinrichtung 13 an diejenige Sammelschienendifferentialschutzeinrichtung weiterleiten, die die mit der fehlerbehafteten Anschlussseite verbundene Sammelschiene überwacht; dies ist im beispielhaften Szenario gemäß Figur 2 die erste Sammelschienendifferentialschutzeinrichtung SDE1.

Sobald die erste Sammelschienendifferentialschutzeinrichtung SDE1 die Fehlerinformation FI oder einen entsprechenden Abschaltbefehl ASB von der Kuppelungsdifferentialschutzeinrichtung 10 erhält, wird sie vorzugsweise unverzüglich die Steuerbefehle zum Öffnen der ihr zugeordneten Abzweigschalter AS1 1-AS13 erzeugen, um zu verhindern, dass die Sammelschiene 10 die Fehlerstelle mit elektrischem Strom speist.

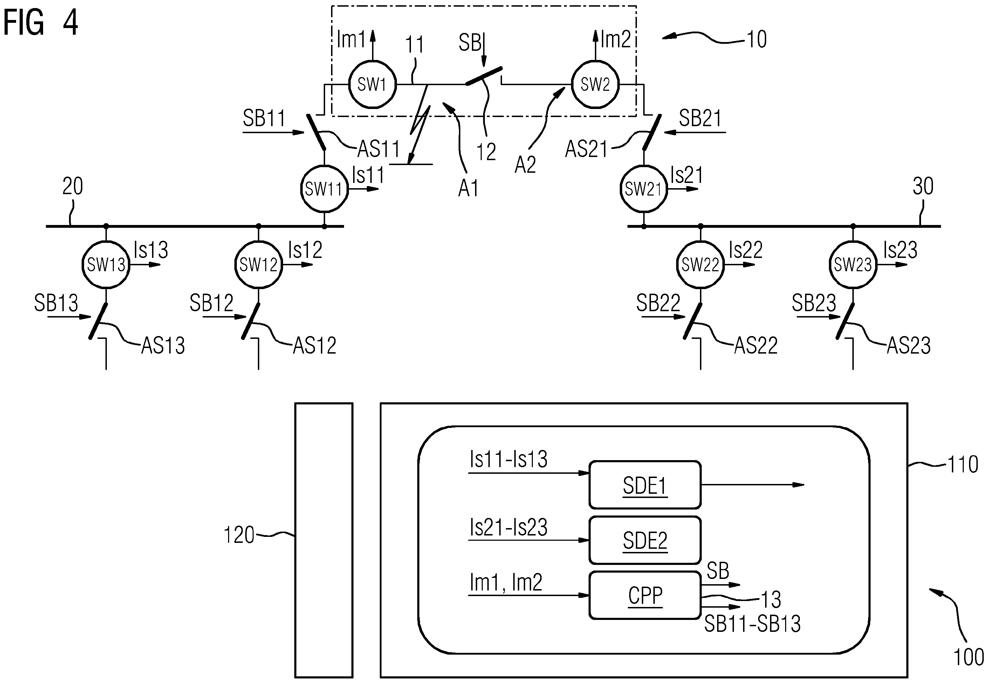

Die Figur 4 zeigt anhand der Anordnung gemäß Figur 1 eine als besonders vorteilhaft angesehene Ausführungsvariante der Arbeitsweise der Auswerteinrichtung 13. Bei der Ausführungsvariante gemäß Figur 4 erzeugt die Auswerteinrichtung 13 unmittelbar selbst die Steuerbefehle SB11-SB13 zum Öffnen der Abzweigschalter AS11-AS13 der ersten Sammelschiene 20, sodass die erste Sammelschienendifferentialschutzeinrichtung SDE1 diesbezüglich umgangen und die resultierende Abschaltzeit deutlich reduziert wird.

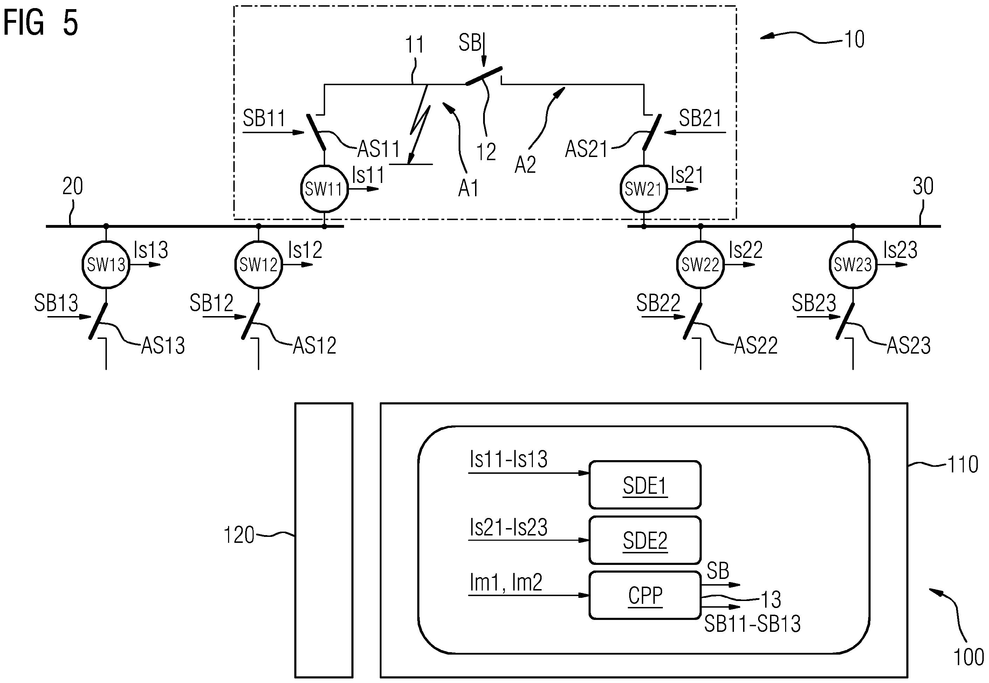

Die Figur 5 zeigt eine weitere Anordnung, die mit einem zweiten Ausführungsbeispiel für eine erfindungsgemäße Kuppelungsdifferentialschutzeinrichtung 10 ausgestattet ist und anhand derer nachfolgend weitere Ausführungsbeispiele für erfindungsgemäße Kupplungsdifferentialschutzverfahren erläutert werden.

Bei der Anordnung gemäß Figur 5 ist die Kuppelungsdifferentialschutzeinrichtung 10 nicht mit eigenen Stromwandlern SW1 und SW2 zum Messen des durch den Kuppelschalter 12 fließenden Stroms ausgestattet. Stattdessen verwendet die Auswerteinrichtung 13 der Kuppelungsdifferentialschutzeinrichtung 10 die Messsignale Is11 und Is21 der beiden elektrisch nächstgelegenen Stromwandler SW11 und SW21 der beiden Sammelschienen 20 und 30.

Die Messsignale Is11 und Is21 der beiden elektrisch am dichtesten an dem Kuppelschalter 12 liegenden Stromwandler SW11 und SW21 werden also in vorteilhafter Weise jeweils doppelt genutzt, nämlich sowohl von der Sammelschienendifferentialschutzeinrichtung der jeweiligen Sammelschiene 20 bzw. 30 zur Durchführung des Sammelschienendifferentialschutzverfahrens als auch von der Kuppelungsdifferentialschutzeinrichtung 10 zur Durchführung des Kupplungsdifferentialschutzverfahrens.

Im Übrigen gelten die obigen Ausführungen im Zusammenhang mit den Figuren 1 bis 4 für das Ausführungsbeispiel gemäß Figur 5 entsprechend.

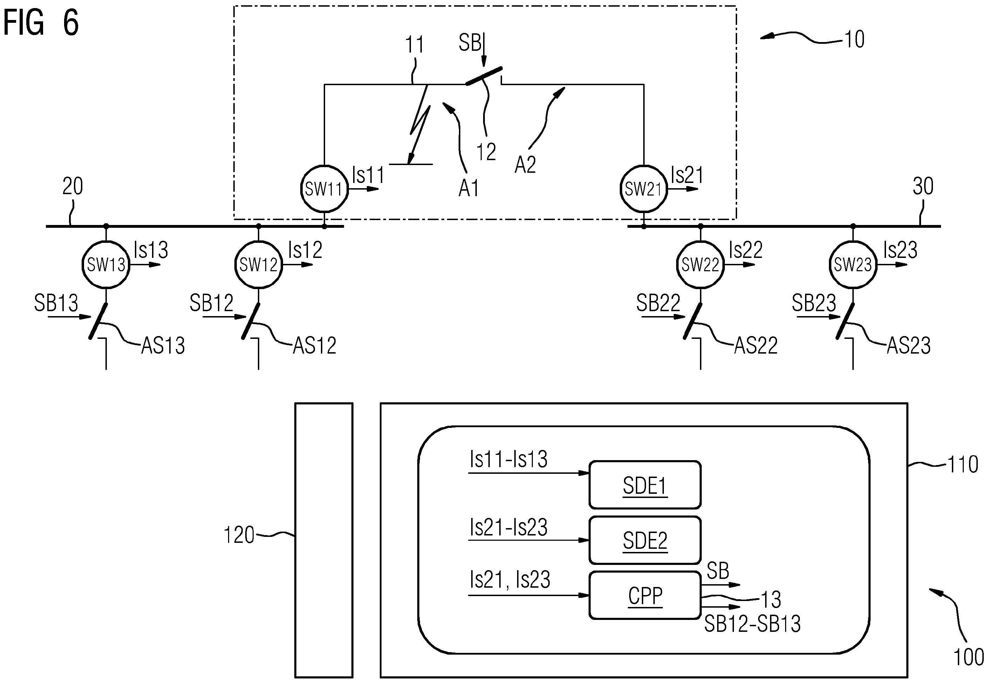

Die Figur 6 zeigt als drittes Ausführungsbeispiel eine Ausführungsvariante des zweiten Ausführungsbeispiels gemäß Figur 5. Bei der Ausführungsvariante gemäß Figur 6 verwendet die Auswerteinrichtung 13 der Kuppelungsdifferentialschutzeinrichtung 10 - analog zum dem zweiten Ausführungsbeispiel gemäß Figur 5 - die Messsignale Is11 und Is21 der beiden elektrisch nächstgelegenen Stromwandler SW11 und SW21 der beiden Sammelschienen 20 und 30.

Die beiden Sammelschienen 20 und 30 sind an der Schnittstelle zu dem Kuppelschalter 12 - anders als bei dem zweiten Ausführungsbeispiel gemäß Figur 5 - jedoch nicht mit eigenen Abzweigschaltern AS11 bzw. AS21 ausgestattet, stattdessen nutzen sie jeweils den Kuppelschalter 12 als "eigenen" Abzweigschalter:
Die erste Sammelschienendifferentialschutzeinrichtung SDE1 wertet also die Messsignale Is11 bis Is13 ihrer Abzweigstromwandler SW11-SW13 aus und öffnet im Falle eines von ihr erkannten Fehlers mittels der Steuerbefehle SB12, SB13 und SB die ihr zugeordneten Abzweigschalter AS12 und AS13 sowie den Kuppelschalter 12 und trennt dadurch die erste Sammelschiene 20 elektrisch ab.

Die zweite Sammelschienendifferentialschutzeinrichtung SDE2 wertet entsprechend die Messsignale Is21 bis Is23 der Abzweigstromwandler SW21-SW23 aus und öffnet im Falle eines von ihr erkannten Fehlers mittels der Steuerbefehle SB, SB22 und SB23 die zugeordneten Abzweigschalter AS22 und AS23 sowie den Kuppelschalter 12 und trennt dadurch die zweite Sammelschiene 20 elektrisch ab.

Die Auswerteinrichtung 13 der Kuppelungsdifferentialschutzeinrichtung 10 erkennt anhand der Messsignale Is11 und Is21 der beiden elektrisch nächstgelegenen Stromwandler SW11 und SW21 einen etwaigen Fehler innerhalb des durch die beiden genannten Stromwandler SW11 uns SW21 begrenzten Kuppelabschnitts 11, wie dies im Zusammenhang mit der Figur 5 erläutert worden ist, und öffnet im Fehlerfall den Kuppelschalter 12 und alle Abzweigschalter derjenigen der beiden Sammelschienen, die an die vom Fehler betroffene Seite angeschlossen ist. Bei der in der Figur 6 gezeigten Fehlersituation öffnet die Auswerteinrichtung 13 also die der ersten Sammelschiene 20 zugeordneten Abzweigschalter AS12 und AS13 sowie den Kuppelschalter 12. Alternativ oder zusätzlich kann sie auch die Sammelschienendifferentialschutzeinrichtung der fehlernahen Sammelschiene, hier also die erste Sammelschienendifferentialschutzeinrichtung SDE1 der ersten Sammelschiene 20 dazu auffordern, die Abzweigschalter AS12 und AS13 zu öffnen.

Im Übrigen gelten die obigen Ausführungen im Zusammenhang mit den Figuren 1 bis 5 für das Ausführungsbeispiel gemäß Figur 6 entsprechend.

Bei den in den Figuren gezeigten Ausführungsbeispielen erstreckt sich der Kuppelabschnitt 11 jeweils auf den Bereich zwischen den beiden Stromwandlern (den Stromwandlern SW1 und SW2 bzw. SW11 und SW21), deren Messsignale von der Kuppelungsdifferentialschutzeinrichtung 10 bzw. deren Auswerteinrichtung 13 verarbeitet bzw. berücksichtigt werden.

Abschließend sei erwähnt, dass die Merkmale aller oben beschriebenen Ausführungsbeispiele untereinander in beliebiger Weise kombiniert werden können, um weitere andere Ausführungsbeispiele der Erfindung zu bilden.

Auch können alle Merkmale von Unteransprüchen jeweils für sich mit jedem der nebengeordneten Ansprüche kombiniert werden, und zwar jeweils für sich allein oder in beliebiger Kombination mit einem oder mehreren anderen Unteransprüchen, um weitere andere Ausführungsbeispiele zu erhalten.

### Bezugszeichenliste

- 10: Kuppelungsdifferentialschutzeinrichtung
- 11: Kuppelabschnitt
- 12: Kuppelschalter
- 13: Auswerteinrichtung
- 20: erste Sammelschiene
- 30: zweite Sammelschiene
- 100: Datenverarbeitungsanlage
- 110: Speicher
- 120: Recheneinrichtung

- A1: erste Anschlussseite
- A2: zweite Anschlussseite
- AS11-AS13: Abzweigschalter
- AS21-AS23: Abzweigschalter
- ASB: Abschaltbefehl
- CPP: Computerprogrammprodukt
- FI: Fehlerinformation
- IO: Wert
- Im1: erstes strombezogenes Messsignal
- Im2: zweites strombezogenes Messsignal
- Is11-Is13: Messsignal
- Is21-Is23: Messsignal
- SB: Steuerbefehl
- SB11-SB13: Steuerbefehl
- SB21-SB23: Steuerbefehl
- SDE1: erste Sammelschienendifferentialschutzeinrichtung
- SDE2: zweite Sammelschienendifferentialschutzeinrichtung
- SW1: Stromwandler
- SW2: Stromwandler
- SW11-SW13: Abzweigstromwandler
- SW21-SW23: Abzweigstromwandler
- t: Zeit
- t0: Zeitpunkt

## Patentansprüche

1. Kupplungsdifferentialschutzverfahren zum Überwachen eines Kuppelabschnitts (11), der einen zwei Sammelschienen (20, 30) verbindenden Kuppelschalter (12) umfasst, wobei bei dem Verfahren
- mit einem einer ersten Anschlussseite (A1) des Kuppelschalters (12) zugeordneten Stromwandler (SW1) der Strom auf der ersten Anschlussseite (A1) unter Bildung eines ersten Messsignals (Im1) gemessen wird,
- mit einem einer zweiten Anschlussseite (A2) des Kuppelschalters (12) zugeordneten Stromwandler (SW2) der Strom auf der zweiten Anschlussseite (A2) unter Bildung eines zweiten Messsignals (Im2) gemessen wird und
- auf einen Fehler erkannt und der Kuppelschalter (12) geöffnet wird, wenn das erste und zweite Messsignal (Im1, Im2) über ein vorgegebenes Maß hinaus voneinander abweichen,
**dadurch gekennzeichnet, dass**
ermittelt wird, ob der Fehler auf der ersten Anschlussseite (A1) oder auf der zweiten Anschlussseite (A2) aufgetreten ist, indem nach dem Öffnen des Kuppelschalters (12) der zeitliche Verlauf des ersten und zweiten Messsignals (Im1, Im2) beobachtet wird und in Abhängigkeit von den zeitlichen Verläufen der Messsignale (Im1, Im2) unmittelbar nach dem Öffnungsvorgang die erste und/oder die zweite Anschlussseite (A1, A2) als vom Fehler betroffen oder fehlerfrei identifiziert wird.

2. Kupplungsdifferentialschutzverfahren nach Anspruch 1,
**dadurch gekennzeichnet, dass**
diejenige der beiden Anschlussseiten (A1) als vom Fehler betroffen angesehen wird, bei der das Messsignal (Im1) trotz Öffnen des Kuppelschalters (12) im Wesentlichen unverändert bleibt oder ansteigt.

3. Kupplungsdifferentialschutzverfahren nach einem der voranstehenden Ansprüche, **dadurch gekennzeichnet, dass**
diejenige der beiden Anschlussseiten (A1) als vom Fehler betroffen angesehen wird, bei der das Messsignal (Im1) ansteigt oder um maximal 10 % abfällt.

4. Kupplungsdifferentialschutzverfahren nach einem der voranstehenden Ansprüche, **dadurch gekennzeichnet, dass**
diejenige der beiden Anschlussseiten (A2) als fehlerfrei angesehen wird, bei der das Messsignal (Im2) in Reaktion auf den Öffnungsvorgang um mindestens 20 % einbricht.

5. Kupplungsdifferentialschutzverfahren nach einem der voranstehenden Ansprüche, **dadurch gekennzeichnet, dass**
diejenige der beiden Anschlussseiten (A2) als fehlerfrei angesehen wird, bei der das Messsignal (Im2) in Reaktion auf den Öffnungsvorgang auf Null abfällt.

6. Kupplungsdifferentialschutzverfahren nach einem der voranstehenden Ansprüche, **dadurch gekennzeichnet, dass**
nach dem Identifizieren der vom Fehler betroffenen Anschlussseite (A1) die an diese Anschlussseite (A1) angeschlossene Sammelschiene (20) von einem an diese angeschlossenen Energieverteilnetz abgetrennt wird.

7. Kupplungsdifferentialschutzverfahren nach einem der voranstehenden Ansprüche, **dadurch gekennzeichnet, dass**
nach dem Identifizieren der fehlerfreien Anschlussseite (A2) die andere Anschlussseite (A1) vom Energieverteilnetz abgetrennt wird.

8. Kupplungsdifferentialschutzverfahren nach einem der voranstehenden Ansprüche, **dadurch gekennzeichnet, dass**
die Sammelschienen (20, 30) jeweils mit einer Sammelschienendifferentialschutzeinrichtung (SDE1, SDE2) überwacht werden, die für jeden Abzweig der jeweiligen Sammelschiene (20, 30) jeweils einen Abzweigschalter (AS11-AS13, AS21-AS23) umfasst und im Falle eines sammelschienenbezogenen Fehlers ihre zugeordnete Sammelschiene (20, 30) durch Öffnen der Abzweigschalter (AS11-AS13, AS21-AS23) von dem zugeordneten Energieverteilnetz abtrennt.

9. Kupplungsdifferentialschutzverfahren nach Anspruch 8, **dadurch gekennzeichnet, dass**
nach dem Identifizieren der vom Fehler betroffenen Anschlussseite (A1) die an diese Anschlussseite (A1) angeschlossene Sammelschiene (20) von dem an diese Sammelschiene (20) angeschlossenen Energieverteilnetz abgetrennt wird, indem die Abzweigschalter (AS11-AS13) der Sammelschienendifferentialschutzeinrichtung (SDE1) der jeweiligen Sammelschiene (20) geöffnet werden.

10. Kupplungsdifferentialschutzverfahren nach Anspruch 9, **dadurch gekennzeichnet, dass**
nach dem Identifizieren der vom Fehler betroffenen Anschlussseite (A1) die an diese Anschlussseite (A1) angeschlossene Sammelschiene (20) von dem Energieverteilnetz abgetrennt wird, indem ein Abschaltbefehl (ASB) und/oder eine die Anschlussseite (A1), die Sammelschiene (20) und/oder die Sammelschienendifferentialschutzeinrichtung (SDE1) identifizierende Fehlerinformation (FI) an die Sammelschienendifferentialschutzeinrichtung (SDE1) übermittelt wird und die Sammelschienendifferentialschutzeinrichtung (SDE1) in Reaktion auf den Abschaltbefehl (ASB) oder die Fehlerinformation (FI) ihre Abzweigschalter (AS11-AS13) öffnet.

11. Kupplungsdifferentialschutzverfahren nach einem der voranstehenden Ansprüche 8 bis 10, **dadurch gekennzeichnet, dass**
nach dem Identifizieren der vom Fehler betroffenen Anschlussseite (A1) die an diese Anschlussseite (A1) angeschlossene Sammelschiene (20) von dem Energieverteilnetz abgetrennt wird, indem unter Umgehung der Sammelschienendifferentialschutzeinrichtung (SDE1) die Abzweigschalter (AS11-AS13) der Sammelschienendifferentialschutzeinrichtung (SDE1) unmittelbar geöffnet werden.

12. Kupplungsdifferentialschutzverfahren nach einem der voranstehenden Ansprüche 7 bis 11, **dadurch gekennzeichnet, dass**
- der der ersten Anschlussseite (A1) des Kuppelschalters (12) zugeordnete Stromwandler (SW1) ein abzweigbezogener Stromwandler (SW1) der Sammelschienendifferentialschutzeinrichtung (SDE1) einer ersten der beiden Sammelschienen (20) ist und
- der der zweiten Anschlussseite (A2) des Kuppelschalters (12) zugeordnete Stromwandler (SW2) ein abzweigbezogener Stromwandler (SW2) der Sammelschienendifferentialschutzeinrichtung (SDE2) einer zweiten der beiden Sammelschienen (30) ist.

13. Kuppelungsdifferentialschutzeinrichtung (10) zum Überwachen eines Kuppelabschnitts (11), der einen zwei Sammelschienen (20, 30) verbindenden Kuppelschalter (12) umfasst, insbesondere zum Durchführen eines Kupplungsdifferentialschutzverfahrens nach einem der voranstehenden Ansprüche, mit einer Auswerteinrichtung (13), die dazu ausgestaltet ist, auf einen Fehler zu schließen und einen das Öffnen des Kuppelschalters (12) auslösenden Steuerbefehl (SB) zu erzeugen, wenn ein erstes Messsignal (Im1), das einen auf einer ersten Anschlussseite (A1) des Kuppelschalters (12) fließenden Strom beschreibt, von einem zweiten Messsignal (Im2), das einen auf der zweiten Anschlussseite (A2) des Kuppelschalters (12) fließenden Strom beschreibt, über ein vorgegebenes Maß hinaus abweicht, **dadurch gekennzeichnet, dass**
die Auswerteinrichtung (13) außerdem dazu ausgestaltet ist, nach dem Öffnen des Kuppelschalters (12) den zeitlichen Verlauf des ersten und zweiten Messsignals (Im1, Im2) zu beobachten und in Abhängigkeit von den Verläufen der Messsignale (Im1, Im2) unmittelbar nach dem Öffnungsvorgang die erste und/oder die zweite Anschlussseite (A1, A2) als vom Fehler betroffen oder als fehlerfrei zu identifizieren.

14. Computerprogrammprodukt (CPP), **dadurch gekennzeichnet, dass**
das Computerprogrammprodukt (CPP) Programmbefehle umfasst, um eine Datenverarbeitungsanlage (100) zu veranlassen, die Auswerteinrichtung (13) der Kuppelungsdifferentialschutzeinrichtung (10) gemäß Anspruch 13 zu bilden und/oder ein Kupplungsdifferentialschutzverfahren nach einem der voranstehenden Ansprüche 1 bis 12 durchzuführen.

15. Datenverarbeitungsanlage (100), **dadurch gekennzeichnet, dass**
die Datenverarbeitungsanlage (100) mit einem Computerprogrammprodukt (CPP) nach Anspruch 14 programmiert ist oder zumindest ein Computerprogrammprodukt (CPP) nach Anspruch 14 in einem Speicher (110) der Datenverarbeitungsanlage (100) abgespeichert ist.
